# EUROPEAN PATENT SPECIFICATION

(11) **EP 3 062 329 B1**
(45) Date of publication and mention of the grant of the patent: **14.12.2016**
(21) Application number: 15156537.1
(22) Date of filing: 25.02.2015
(51) Int. Cl.: H01J 37/30

(54) **Multi-source GIS for particle-optical apparatus**
GIS mit mehreren Quellen für eine teilchenoptische Vorrichtung
GIS multisource pour appareil optique à particules

(43) Date of publication of application: 31.08.2016
(73) Proprietor: FEI COMPANY, Hillsboro, Oregon 97124-5793 (US)
(72) Inventor: Mulders, Hans, 5632 SB Eindhoven (NL); Trompenaars, Piet, 5038 PK Tilburg (NL); Dona, Pleun, 5504 KN Veldhoven (NL)
(74) Representative: Bakker, Hendrik

(56) References cited:
- US-A- 5 055 696
- US-A- 6 113 983
- US-A1- 2013 137 250
- Vinzenz Frieldi ET AL: "Gas Injections Systems for FEB and FIB Processing - Theory and Experiment" In: "Oxford Series in Nanomanufacturing : Nanofabrication Using Focused Ion and Electron Beams : Principles and Applications", 1 January 2012 (2012-01-01), Oxford University Press, USA, XP055206220, ISBN: 978-0-19-973421-4 pages 126-183, * page 173 - page 176; figure 3.28 * * * -& "Gas Injection System For Focused Electron & Ion Beams Induced Processes", , 4 August 2015 (2015-08-04), XP055206234, Retrieved from the Internet: URL:http://www.orsayphysics.com/uploads/pr oducts/pdf/GIS-5.pdf [retrieved on 2015-08-04]
- "Parallel Gas Injection System (PGIS) for Use with the NanoBot Nanomanipulator", , 1 January 2011 (2011-01-01), XP055206074, Retrieved from the Internet: URL:http://xidex.com/images/stories/Xidex_ Parallel_Gas_Injection_System_110913.pdf [retrieved on 2015-08-03]

## Description

### Background of the invention

The invention relates to a Gas Injection System (GIS) for applying at least two fluids in the vacuum chamber of a particle-optical apparatus, the gas injection system having two or more channels, each channel connected to an associated reservoir holding a fluid at a first side and having an associated exit opening at the other side, the exit sides individually exiting to the outside of the GIS via a nozzle with a nozzle opening, one of the exit openings is concentric with another exit opening.

The invention further relates to a method using said GIS.

Such a GIS is described in "Nanofabrication using focused ion and electron beams", Ed. Ivo Utke, et al., ISBN 978-0-19-973421-4, more specifically in chapter 3.7.2.3: multinozzle (pages 173-175).

A GIS is used to process a sample, such as a silicon sample. The processing may be Ion Beam Induced Deposition (IBID), where a focused ion beam is directed to the sample and the gas adhered to the sample is split in a part deposited on the sample surface and a, typically gaseous, by-product.
Likewise in Electron Beam Induced Deposition (EBID) a focused electron beam is directed to the sample and the gas adhered to the sample is split in a part deposited on the sample surface and a gaseous by-product.
Not only deposition, but also gas assisted etching or -milling are known to be used.

The before mentioned book chapter mentions that "for sophisticated focused-beam processing, multi-GISs are preferably used, allowing mixing of multiple precursor gases locally in the vacuum chamber above the processing area. This avoids mixing of reactive gases at higher densities inside the supply tubes. Typically, such systems are intended for complex gas chemistries for beam-induced processing."

The book chapter further mentions that a problem that may arise is "gas shadowing effects" on uneven surfaces. A solution to that is the NanoChemix™ marketed by FEI Company, Hillsboro, Oregon, USA. Here three nozzles are used for applying two gases. Two needles (nozzle) are opposing each other and are used for one gas (fluid) and the third needle is used to apply the other gas (fluid), for example a precursor for metal deposition. This not only avoids gas shadowing effects, but also "maintains more homogeneous gas coverage leading to a better floor uniformity or planarity of the processed structure".

It is noted that the precursor is responsible for deposition, but another gas may be used for, for example, *in-situ* cleaning, for example to remove carbon contaminants by oxidizing, or *in-situ* reduction.

When using a single needle, it is common practice to position the exit opening (the nozzle) as close as possible to the target (the sample). In that way only a small area of the sample is exposed to gas and little gas is needed, resulting in a relatively low background pressure of the vacuum chamber where the processing takes place. Distances of 0.5 mm or less from nozzle to sample are commonly used.

When using two opposing nozzles it is implicit that the beam (a focused ion beam or an electron beam) is directed to the sample and hits the sample between the two opposing nozzles. The three nozzles are placed on a circle, the two opposing needles are 0° and 180°, the third needle at 90°, and the beam passing through the center of the circle.
This in turn implies that the nozzles are placed at a distance large enough to let the beam pas between them. A typical distance of at least 1 mm should be kept between the nozzles. This relatively large distance means that a spot of at least 1 mm² is covered with gas, resulting in a corresponding higher background pressure.

Another problem occurring with the three-nozzle approach is that tilt is limited: not only is tilt physically limited by the two opposing nozzles, but even more so by the third nozzle. Another problem is that when tilting the distance between sample and the nozzles changes unevenly (unless the cluster of needles is tilted as well, resulting in a complicated system).

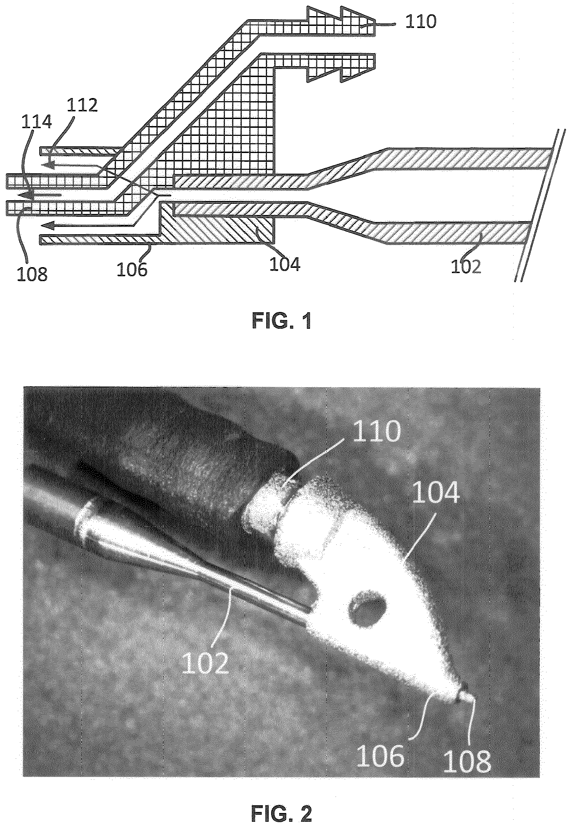

It is noted that US patent no. US5,055,696 discloses an electron beam column with a gas system where three gasses are added to a sample (see its figure 1, gas from bottles 41, 42 and 43 are fed to the sample via nozzle unit 44). Although this nozzle unit is not identical to the GIS discussed before, this discloses concentric gas nozzles.

There is a need for a multi-GIS system where
- Mixing occurs after exiting the nozzles,
- No shadowing occurs,
- When tilting the sample the distance between the sample and each of the nozzles is identical (although maybe different from the distance before tilting),
- The nozzles can be positioned close to the sample.

More specifically there is a need to upgrade an existing single channel GIS to a multi-GIS system.

The invention addresses at least in part said problems.

To that end a first channel of the two or more channels is connected with a positioning unit for positioning the GIS, and at least one other channel of the two or more channels is detachably mounted on the first channel..

Inventors found that when the nozzles are concentric, no shadowing occurs, and also the tilt limitations are much reduced. When the first channel is connected with a positioning unit for positioning the GIS, and another channel is detachably mounted on the first channel, an upgrade of a conventional GIS to a concentric system is possible.

Although concentric nozzles for a GIS may seems hard to make, by using additive manufacturing techniques ("3D printing" of titanium) making of such concentric nozzles proved to be well possible and even to make an 'add-on' nozzle that can be mounted on an existing single channel system.
It is noted that this embodiment also works when a part of the outer channel is blocked, and the outer nozzle thus not completely surrounds the inner nozzle.

In a preferred embodiment one of the exit openings is concentric with another exit opening and the inner exit opening protrudes through the outer exit opening.

A protruding inner nozzle minimizes mixing and back-streaming of the gas used for the inner nozzle into the outer nozzle.

In another embodiment the fluids are, in working, mixed after exiting the exit opening.

To avoid reaction of the gases in the channels the fluids (gases) should mix after exiting the nozzle. Such reaction could give rise to clogging, heating, and other unwanted effects.

In yet another embodiment a particle-optical apparatus is equipped with a GIS according to the invention.

In an aspect of the invention a method of using a GIS according to the invention is characterized in that at least two fluids are delivered at a flux differing at least two orders of magnitude.

Inventors found that with a prototype of this concentric nozzle it was possible to deliver gases with highly different flux to the sample. As a result a single step process can be used to apply a platinum precursor (MeCpPtMe₃) while directing a jet of oxygen with a much higher flux (Jₒₓ/J_{prec} > 10², preferably Jₒₓ/J_{prec} > 10⁴) platinum tracks with low resistivity (p < 100 µΩ·cm) were obtained, indicating a high purity and dense (void free) structure of the tracks.

In an embodiment of the method a first fluid is a precursor material and a second fluid is reactive to at least one breakdown product of the precursor material.

Preferably the second fluid is delivered with the highest flux.

The second fluid may be an oxidizing fluid (for example O₂, H₂O) or a reducing fluid (for example H₂).

The invention is now elucidated using figures, in which identical reference numerals refer to corresponding features. To that end:
Figure 1 shows a schematic drawing of an add-on dual nozzle,
Figure 2 shows a micrograph of the add-on nozzle of figure 1, and
Figure 3 shows a micrograph of a detail of figure 2.
Figure 4 shows an arrangement used for depositing high purity metals.
Figure 5 shows a schematic front view of other types of nozzles.

Figure 1 shows a schematic drawing of an add-on dual nozzle.

Figure 1 shows an existing single channel needle 102 (also referred to as a single channel nozzle) to which an "add-on" nozzle is attached. Not shown, but clear to the skilled person, is that the existing single channel needle is connected to a position unit for finely positioning the needle with respect to a sample. The "add-on" nozzle has an outer body 104 removably attached to the existing single channel needle 102. The outer body of the add-on is connected to an outer nozzle 106, which allows the outflow of gas 112 flowing through the single channel needle 102. Gas inlet 110 is connected via a hose (not shown) to a gas reservoir. It is connected via a channel to nozzle108. The nozzle 108 protrudes through outer nozzle 106. As a result the gas 114 flowing though nozzle 108 is surrounded by a gas envelope flowing from the nozzle 106. At the sample these gasses will have mixed.

It is noted that, although in this schematic drawing the parts 104/106 and 108/110 are shown as separate parts (different shading), in a preferred embodiment all these parts are one part, formed by added manufacturing ("3D printing").

It is further mentioned that in the above paragraphs the words channel and nozzle are used interchangeable to describe the same items.

It is noted that the inner nozzle 108 need not protrude through nozzle 106, but that slight back-streaming may then be expected, possibly resulting in the formation of reaction products inside nozzle 106.

Figure 2 shows a micrograph of the add-on nozzle of figure 1. This dual nozzle is made using 3D printing of titanium.

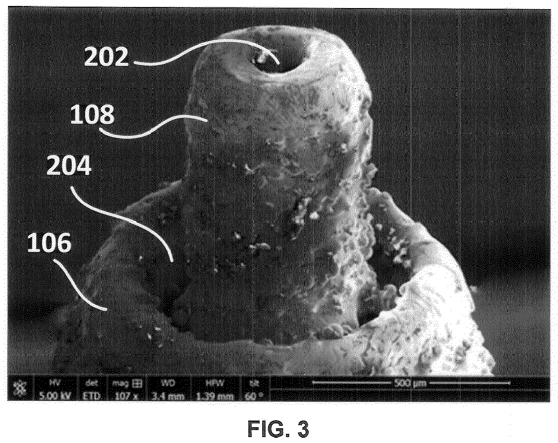

Figure 3 shows a micrograph of a detail of figure 2.

Figure 3 shows the inner, protruding, nozzle 108, surrounded by the outer nozzle 106. Between these nozzles an outflow opening 304 is visible, through which the gas supplied by the needle 102 (see figure 2) can flow. The inner nozzle has a central opening 302 through which the gas supplied via gas inlet 110 (see figure 2) can flow.

The presence of two concentric, or at least closely spaced, nozzles, enables two gasses (or fluids) to be applied simultaneously without shadowing to occur. It also enables a first gas to be applied at a first flux and a second gas to be applied with a much higher flux, for example with a flux two orders of magnitude (thus: 100x) higher than the first flux.

As known to the skilled person a deposition of a material, for example a metal, often contains a large fraction of contaminants, such as carbon, due to the fact that not all residual material are turned in volatile by-products. By a post-treatment of a sample with for example oxygen exposure while directing a beam of electrons to the sample, part of these contaminants are removed. As an example: Mehendale S. et al., "A new sequential EBID process for the creation of pure Pt structures from MeCpPtMe3", Nanotechnology 24 (2013) 145303 (7pp), further referred to as Mehendale et al., describes a Pt layer deposited with an electron beam using MeCpPtMe₃ as a (platinum) precursor. The resistance of a track was measured to be 107 µΩ·cm. EDX analysis showed a large amount of carbon in the deposit. Post-treatment with oxygen while irradiating with electrons resulted in a drop of resistance to 88 +/- 10 µΩ·cm. However, inspection showed that the deposited metal was not void free.

This two-step method, although giving good results, is time consuming.

By applying the same precursor and under comparable conditions, the precursor flowing from the outer nozzle and O₂ at a much higher flux from the inner nozzle resulted in a track with a specific resistivity of 60 +/- 5 µΩ·cm.

This compares qualitatively favorably to the results of the two-step method as described by Mehendale et al. and it is also a much quicker method, as it eliminated the positioning of the second GIS providing the oxygen and the following processing step with O₂.

The invention thus enables a quicker processing (purification) of deposited materials in which, for example, carbon contamination is present.

Likewise one-step processing can be performed with a reducing gas instead of an oxidizing gas. Simultaneous with two needles: also good, difficult to position, not completely void free, slightly higher resistance.

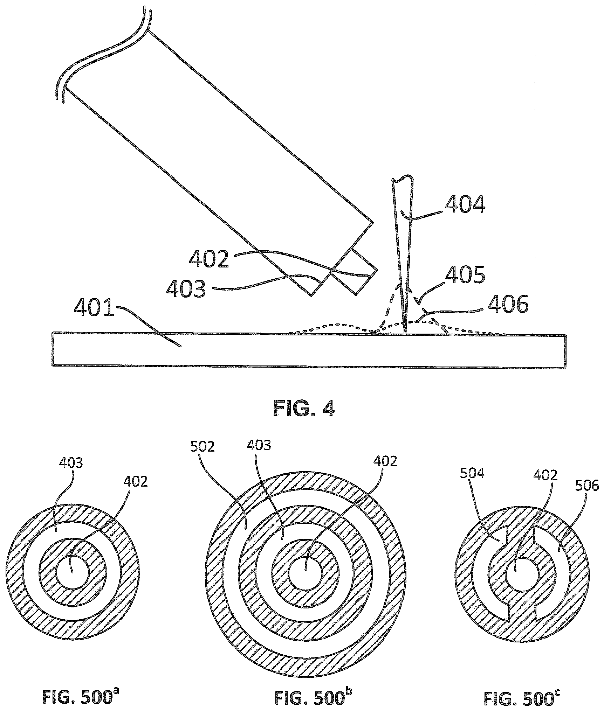

Figure 4 shows an arrangement used for depositing high purity metals.

Figure 4 shows an inner nozzle with an opening 402 and an outer nozzle with an opening 403. From these openings a gas flow is directed to a sample 401. The outer nozzle has a low flux of precursor gas exiting the outer opening. Because of the low flux the amount of gas introduced to evacuated volume in which the process takes place is limited. It is noted that the gas directed to the sample adhere to the sample, but after a time leave the sample to be evacuated by vacuum pumps. The concentration of precursor gas adhering to the surface of the sample is schematically given by curve 406. This shows a lopsided curve, as the nozzle is placed off-axis. The minimum near the middle of the curve is due to shadowing of the outer nozzle by the inner nozzle. However, only where the beam of energetic electrons 404 hit the sample surface, precursor molecules are dissociated. Here a high concentration of for example oxygen is realized by directing a beam of molecules from nozzle opening 402 at a high flux. The high flux, together with the small distance of the opening to the sample, results in an excess of oxygen where the beam hits the sample (concentration of oxygen schematically shown as curve 405). It is noted that the excess of precursor molecules at other positions is not a problem, as these molecules are only adsorbed, and desorb from the sample intact.

The result of this is that all carbon reacts with the oxygen (which is dissociated at the beams interaction position as well) and form volatile CO and CO₂ molecules, which desorb from the sample surface. The resultant deposit proved to be homogeneous (void free) and showed a low specific resistance.

It is noted that, although the example given in the above, explains the invention using a platinum precursor and oxygen to form volatile by-products, the skilled person will recognize that other precursors and other oxidizing or reactive materials can be used. Also, the example worked at room temperature, but the invention works equally well with other gasses at other temperatures.

The invention has been elucidated for one inner nozzle and a concentric outer nozzle. The skilled person recognizes that similar results can be obtained by multi-nozzle design in which three or even more nozzles are concentric to each other, or where two nozzles surround the inner nozzle. In the latter case slight shadowing can be expected.

Figure 5 shows a front view of other types of nozzles.

Figure 500^{a} shows a front view of the nozzle with two concentric outflow openings, an inner opening 402 and a surrounding, outer opening 403.

Figure 500^{b} shows a front view where a third outflow opening 502 surround the openings 402 and 403.

Figure 500^{c} shows a front view where an outflow opening 504 and an outflow opening 506 are spaced round central opening 402.

Many more options will be clear to the skilled artisan.

It is mentioned that the invention is explained using an add-on nozzle, enabling to upgrade an existing GIS to a GIS with concentric nozzles. It will be clear how to implement a non-add-on version.

## Claims

1. A Gas Injection System (GIS) for applying at least two fluids in the vacuum chamber of a particle-optical apparatus, the gas injection system having two or more channels(102, 110), each channel connected to an associated reservoir holding a fluid at a first side and having an associated exit opening at the other side, the exit sides individually exiting to the outside of the GIS via a nozzle with a nozzle opening, one of the exit openings (106) is concentric with another exit opening (108), **characterized in that** a first channel (102) of the two or more channels is connected with a positioning unit for positioning the GIS, and at least one other channel (110) of the two or more channels is detachably mounted on the first channel.

2. The GIS of claim 1 in which the inner exit opening (108) protrudes through the outer exit opening (106).

3. The GIS of any of the preceding claims in which, in working, the fluids are mixed after exiting the exit opening.

4. Particle-optical apparatus equipped with a GIS according to any of the preceding claims.

5. A method of using a GIS according to any of the preceding claims, the method **characterized in that** in working at least two fluids exit the GIS, one fluid exiting the GIS with a first flux and the other fluid exiting the GIS with a flux differing at least two orders of magnitude.

6. The method of using a GIS according to claim 5 in which a first fluid is a precursor material and a second fluid is reactive to at least one breakdown product of the precursor material.

7. The method of claim 6 in which the second fluid is delivered with a flux at least two orders of magnitude than the first fluid.

8. The method of claims 6 or 7 in which the second fluid is a reducing fluid or an oxidizing fluid.

9. The method of claim 8 in which the fluid is a reducing fluid comprising H₂

10. The method of claim 8 in which the fluid is an oxidizing fluid comprising O₂ or H₂O.

## Patentansprüche

1. Gaseinspritzsystem (GIS) zum Anwenden von wenigstens zwei Fluiden in der Vakuumkammer einer teilchenoptischen Vorrichtung, wobei das Gaseinspritzsystem zwei oder mehr Kanäle (102, 110) hat, wobei jeder Kanal mit einem zugehörigen Vorratsbehälter verbunden ist, der ein Fluid auf einer ersten Seite hält und eine zugehörige Austrittsöffnung auf der anderen Seite hat, wobei die Austrittsseiten einzeln über eine Düse mit einer Düsenöffnung nach außerhalb des GIS austreten, wobei eine der Austrittsöffnungen (106) konzentrisch mit einer anderen Austrittsöffnung (108) ist, **dadurch gekennzeichnet, dass** ein erster Kanal (102) der zwei oder mehr Kanäle mit einer Positionierungseinheit zum Positionieren des GIS verbunden ist und wenigstens ein anderer Kanal (110) der zwei oder mehr Kanäle abnehmbar an dem ersten Kanal montiert ist.

2. GIS nach Anspruch 1, wobei die innere Austrittsöffnung (108) durch die äußere Austrittsöffnung (106) vorsteht.

3. GIS nach einem der vorhergehenden Ansprüche, in dem im Betrieb die Fluide miteinander vermischt werden, nachdem sie aus der Austrittsöffnung austreten.

4. Teilchenoptische Vorrichtung, die mit einem GIS nach einem der vorhergehenden Ansprüche ausgerüstet ist.

5. Verfahren zur Verwendung eines GIS nach einem der vorhergehenden Ansprüche, wobei das Verfahren **dadurch gekennzeichnet ist, dass** im Betrieb wenigstens zwei Fluide aus dem GIS austreten, wobei ein Fluid mit einem ersten Fluss aus dem GIS austritt und das andere Fluid mit einem anderen Fluss, der sich um mindestens zwei Größenordnungen unterscheidet, aus dem GIS austritt.

6. Verfahren zur Verwendung eines GIS nach Anspruch 5, wobei ein erstes Fluid ein Vorläufermaterial ist und ein zweites Fluid mit wenigstens einem Abbauprodukt des Vorläufermaterials reaktiv ist.

7. Verfahren nach Anspruch 6, wobei das zweite Fluid mit einem Fluss geliefert wird, der wenigstens zwei Größenordnungen größer als der des ersten Fluids ist.

8. Verfahren nach Anspruch 6 oder 7, wobei das zweite Fluid ein reduzierendes Fluid oder ein oxidierendes Fluid ist.

9. Verfahren nach Anspruch 8, wobei das Fluid ein reduzierendes Fluid ist, das H₂ aufweist.

10. Verfahren nach Anspruch 8, wobei das Fluid ein oxidierendes Fluid ist, das O₂ oder H₂O aufweist.

## Revendications

1. Système d'injection de gaz (GIS) pour appliquer au moins deux liquides dans la chambre sous vide d'un dispositif optique à particules, le système d'injection de gaz ayant deux canaux ou plus (102, 110), chaque canal connecté à un réservoir associé contenant un liquide à un premier côté et ayant une ouverture de sortie associée de l'autre côté, les côtés de sortie débouchant individuellement vers l'extérieur du GIS par l'intermédiaire d'une buse équipée d'une ouverture de buse, une des ouvertures de sortie (106) est concentrique avec une autre ouverture de sortie (108), **caractérisé en ce qu'**un premier canal (102) des deux canaux ou plus est relié à une unité de positionnement destinée à positionner le GIS, et au moins un autre canal (110) des deux canaux ou plus est monté de manière amovible sur le premier canal.

2. Système d'injection de gaz selon la revendication 1, dans lequel l'ouverture de sortie interne (108) fait saillie à travers l'ouverture de sortie externe (106).

3. Système d'injection de gaz selon l'une quelconque des revendications précédentes, dans lequel, en opération, les liquides sont mélangés après être sortis des ouvertures de sortie.

4. Dispositif optique à particules équipé d'un GIS selon l'une quelconque des revendications précédentes.

5. Procédé utilisant un GIS selon l'une quelconque des revendications précédentes, le procédé étant **caractérisé en ce qu'**il traite au moins deux liquides sortant du GIS, un liquide sortant du GIS selon un premier flux et l'autre liquide sortant du GIS selon un flux différent d'au moins deux ordres d'amplitude.

6. Procédé utilisant un GIS selon la revendication 5, dans lequel un premier liquide est un matériau précurseur et un second liquide est réactif à au moins un produit de rupture du matériau précurseur.

7. Procédé selon la revendication 6, dans lequel le second liquide est fourni selon un flux d'au moins deux ordres d'amplitude que le premier liquide.

8. Procédé selon les revendications 6 ou 7 dans lequel le second liquide est un liquide de réduction ou un liquide d'oxydation.

9. Procédé selon la revendication 8, dans lequel le liquide est un liquide de réduction comprenant du H₂.

10. Procédé selon la revendication 8 dans lequel le liquide est un liquide d'oxydation comprenant du O₂ ou du H₂O.
